# EUROPÄISCHE PATENTANMELDUNG

(11) **EP 1 006 564 A1**
(43) Veröffentlichungstag der Anmeldung: **07.06.2000**
(21) Anmeldenummer: 99123484.0
(22) Anmeldetag: 25.11.1999
(51) Int. Cl.: H01L 21/00, B23K 35/30

(54) **Verfahren zur Herstellung einer Haltevorrichtung für Halbleiterscheiben und nach diesem Verfahren hergestellte Haltevorrichtung**

(30) Priorität: 30.11.1998 DE 19856468
(71) Anmelder: SICO Jena GmbH Quarzschmelze, 07745 Jena (DE)
(72) Erfinder: Nadrag, Walter, 9530 Bad Bleiberg (AT); Jochmann, Peter, 07743 Jena (DE); Sivec, Klaus, 9500 Villach (AT); Zimmermann, Edith, 07616 Graitschen (DE)
(74) Vertreter: Niestroy, Manfred

(57) **Zusammenfassung**

Die Erfindung bezieht sich auf ein Verfahren zur Herstellung einer Vorrichtung, die zum Halten von Halbleiterscheiben (Wafer) während diverser, vorzugsweise thermischer Bearbeitungsprozesse sowie zum Transport von Halbleiterscheiben zwischen verschiedenen Bearbeitungsstationen geeignet ist und die aus mehreren einzeln vorgefertigten Vorrichtungsteilen besteht, die zusammengesetzt und miteinander verbunden werden. Die Erfindung bezieht sich weiterhin auf eine nach dem erfindungsgemäßen Herstellungsverfahren gefertigte Haltevorrichtung für Halbleiterscheiben.

Bei einem Verfahren der eingangs beschriebenen Art werden die Vorrichtungsteile (12,14) zunächst aus ein- oder polykristallinem Silizium getrennt und unabhängig voneinander vorgefertigt und dabei mit zueinander korrespondierenden Paßflächen versehen. Dann werden jeweils benachbarte Vorrichtungsteile (12,14) mit sich gegenüberstehenden Paßflächen in- bzw. aneinandergefügt und die Paßflächen durch Diffusionsschweißen und/oder durch Löten, wobei Germaniumpulver als Lot verwendet wird, miteinander verbunden.

## Beschreibung

Die Erfindung bezieht sich auf ein Verfahren zur Herstellung einer Vorrichtung, die zum Halten von Halbleiterscheiben (Wafer) während diverser, vorzugsweise thermischer Bearbeitungsprozesse sowie zum Transport von Halbleiterscheiben zwischen verschiedenen Bearbeitungsstationen geeignet ist und die aus mehreren einzeln vorgefertigten Vorrichtungsteilen besteht, die zusammengesetzt und miteinander verbunden werden. Die Erfindung bezieht sich weiterhin auf eine nach dem erfindungsgemäßen Herstellungsverfahren gefertigte Haltevorrichtung für Halbleiterscheiben.

Das Anwendungsgebiet der Erfindung ist die Halbleitertechnologie, insbesondere die Waferbearbeitung und das Waferhandling. Hierbei wird eine Vielzahl von im wesentlichen flächenparallel ausgerichteten Halbleiterscheiben bzw. Wafern, aus denen in späteren Herstellungsprozessen z.B. integrierte Schaltkreise gefertigt werden, in einer Haltevorrichtung (Wafer-Boat) aufgenommen und in dieser Haltevorrichtung einzelnen Bearbeitungsschritten unterworfen, wobei die Halbleiterscheiben wie auch die Haltevorrichtung u.a. hohen thermischen Belastungen ausgesetzt sind.

Dieses erfolgt in Reinsträumen in einer fremdstoffreien, hochreinen Atmosphäre, um unkontrollierte und unerwünschte Einlagerungen von fremden Atomen oder Molekülen in das Wafermaterial weitgehend zu verhindern.

Es ist bereits bekannt, eine derartige Haltevorrichtung für Halbleiterscheiben aus Quarz oder gesintertem keramischen Material durch Verschmelzen oder Sintern einzelner Vorrichtungsteile herzustellen. Das ist beispielsweise beschrieben in der DE 39 07 301 A1, Seite 1, Zeile 15 bis 22.

Wegen des herstellungsbedingten Aufwandes, der geforderten Genauigkeit, des erheblichen Reparaturaufwand im Falle eines Materialbruchs usw. wird in der Schrift vorgeschlagen, die Haltevorrichtung durch lösbare Verbindungen der einzelnen Vorrichtungsteile zusammenzusetzen.

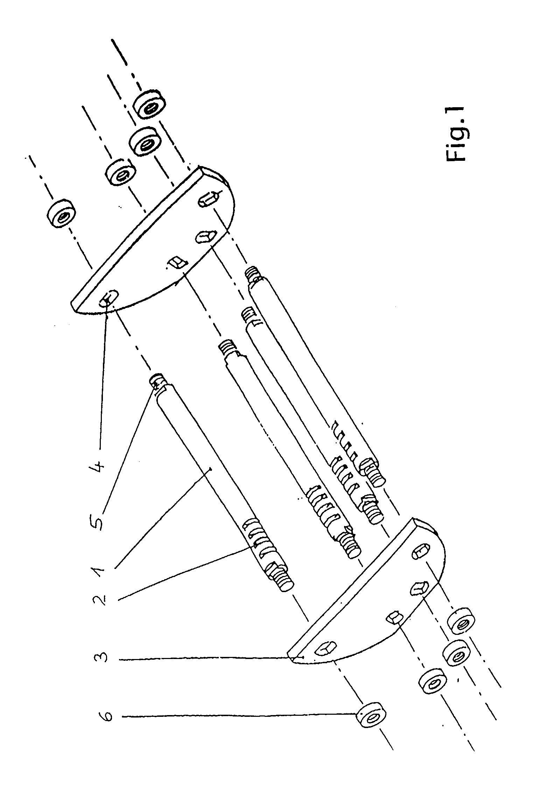

Eine Haltevorrichtung, die dem genannten Stand der Technik entspricht, ist in Fig.1 dargestellt. Hier sind vier rundstabförmige Halteelemente 1 an ihrer den Halbleiterscheiben zugewandten Seite mit spalten- oder nutenförmigen Ausnehmungen 2 versehen, in welche die (zeichnerisch nicht dargestellten) Halbleiterscheiben so eingestellt werden können, daß sie an vier Bereichen ihres äußeren Umfanges in vertikaler, zueinander paralleler Ausrichtung in einem für den jeweiligen Behandlungsschritt erforderlichen Abstand gehalten werden.

Weiterhin sind hierbei zwei Front- bzw. Endteile 3 vorgesehen, die mit Flächen beispielsweise zum Aufstellen der Haltevorrichtung auf eine Unterlage versehen sind. Zur Befestigung der Halteelemente 1 sind an den Front- bzw. Endteilen 3 Öffnungen 4 vorhanden, mit deren Positionen die räumliche Anordnung der Halteelemente 1 festgelegt ist. Die Halteelemente 1 weisen beidseitig an ihren Enden Gewinde 5 auf, die gemeinsam mit Muttern 6 zur Verbindung mit den Front- bzw. Endteilen 3 dienen.

Nachteilig dabei ist, daß derartige Verbindungen insbesondere im Hochtemperaturbereich nicht den Anforderungen an eine stabile und lagegenaue Aufnahme der Halbleiterscheiben genügen, vor allem auch im Hinblick auf die erhebliche Gewichtsbelastung durch die oftmals große Anzahl der aufzunehmenden Halbleiterscheiben. Darüber hinaus erfüllen Haltevorrichtungen aus Quarz zwar die Reinheitsanforderungen, sind jedoch nur bis zu einer Temperatur von 1.057° C, Haltevorrichtungen aus gesintertem Material nur bis 1.250° C gegen Verformung beständig.

Weiterhin sind Haltevorrichtungen bekannt, bei denen die einzelnen Vorrichtungsteile durch Schweißen oder Kleben verbunden sind, wie beispielsweise in JP 08 316 158 A beschrieben. Allerdings kann dabei infolge des Einbringens von Fremdmaterial die Forderungen nach Reinheit, beim Kleben auch die Stabilitätsanforderungen im Hochtemperaturbereich, nicht erfüllt werden. Auch bekannte Ausführungen mit Verbindung der Vorrichtungsteile durch Fügen in Preßpassungen, wie in der Veröffentlichung JP 08 102 446 A dargelegt, können die Anforderungen an den Einsatz im Hochtemperaturbereich nicht erfüllen.

Um den hohen Reinheitsanforderungen genügen zu können, ist gemäß Veröffentlichung JP 06 151 571 A vorgesehen, eine Haltevorrichtung für Halbleiterscheiben aus Einkristall-Silizium herzustellen, wobei jedoch die einzelnen Vorrichtungsteile demontierbar, d.h. wiederum lösbar, miteinander verbunden sind. Auch mit der hier vorgeschlagenen lösbaren Verbindung können die erforderlichen Festigkeits- bzw. Stabilitätsvorraussetzungen im Hochtemperaturbereich nicht erreicht werden.

In Anbetracht der Nachteile des bekannten Standes der Technik liegt der Erfindung die Aufgabe zugrunde, ein Verfahren der eingangs genannten Art und eine nach dem Verfahren hergestellte Haltevorrichtung für Halbleiterscheiben zu schaffen, wobei die Reinheitsanforderungen hinsichtlich der für die Vorrichtungsteile und die Teileverbindungen verwendeten Werkstoffe und auch die mechanische Stabilität der Teileverbindung bis zu Temperaturen von 1.350° C gewährleistet sind.

Erfindungsgemäß werden bei einem Verfahren der eingangs beschriebenen Art die Vorrichtungsteile zunächst aus ein- oder polykristallinem Silizium einzeln vorgefertigt und dabei mit zueinander korrespondierenden Paßflächen versehen, dann die jeweils benachbarten Vorrichtungsteile mit sich gegenüberstehenden Paßflächen in- bzw. aneinandergefügt und schließlich die Paßflächen durch Diffusionsschweißen und/oder durch Löten, wobei Germaniumpulver als Lot verwendet wird, miteinander verbunden.

Das erfindungsgemäße Verfahren gestattet die Herstellung einer Haltevorrichtung für Halbleiterscheiben, die höchsten Reinheitsanforderungen bei Temperaturen bis 1.350° C im Reinstraum entspricht; d.h. eine Abgabe von Verunreinigungen über das für die Halbleitertechnologie zulässige Maß hinaus ist ausgeschlossen.

Dabei ermöglicht die Erfindung zunächst die kostengünstige Herstellung einzelner Vorrichtungsteile, was insbesondere bei geometrisch kompliziert gestalteten Teilen vorteilhaft ist. Im anschließenden Fügeprozeß erfolgt eine unlösbare stoffschlüssige Verbindung der Vorrichtungsteile miteinander, so daß eine hohe mechanische und thermische Stabilität der Haltevorrichtung auch unter Hochtemperaturbedingungen gewährleistet ist. Dies hat für den Temperaturbereich bis 1.350° C und die hohe Gewichtsbelastung durch die große Anzahl aufzunehmender Halbleiterscheiben besondere Bedeutung.

Die Paßflächen werden bevorzugt eben ausgeführt, sie können jedoch in jeder beliebigen Weise gewölbt bzw. gekrümmt sein, wobei natürlich die sich an verschiedenen Vorrichtungsteilen gegenüberstehenden Paßflächen eine miteinander korrespondierende bzw. aufeinander abgestimmte Krümmung aufweisen müssen.

In einer vorteilhaften Ausgestaltung der Erfindung ist vorgesehen, daß die Diffusionsschweißung über einen Zeitraum von ca. drei bis vier Stunden unter einem Anpreßdruck der Vorrichtungsteile gegeneinander von bis zu 10 N/mm² und bei einer Umgebungstemperatur von 1000 °C bis 1300 °C vorgenommen wird. Die Vorrichtungsteile sind während des Schweißprozesses vorzugsweise von atmosphärischer Luft umgeben.

Für diese Verbindung werden die Vorrichtungsteile so vorbereitet, daß die sich gegenüberstehenden Paßflächen zweier benachbarter Vorrichtungsteile bezüglich ihrer Krummung über das gesamte zur Verschweißung vorgesehene Areal hinweg miteinander berühren. So können beispielsweise die Paßflächen eben und parallel zueinander oder auch mit gleicher Krümmung so ausgeführt sein, daß sie sich unter geringsten Spaltausbildung berühren.

In einer besonders bevorzugten Ausgestaltung der Erfindung ist vorgesehen, daß das Löten der Vorrichtungsteile in der Weise erfolgt, daß zunächst pulverisiertes Germanium mit einer Korngröße kleiner 50 µm in einen zwischen den sich gegenüberstehenden Paßflächen zweier Vorrichtungsteile ausgebildeten Spalt eingebracht wird und anschließend die Vorrichtungsteile bei einem Druck von kleiner 30 mbar und bei der Temperatur von 900 °C bis 1350 °C miteinander verbunden werden. Hierbei wirkt das Germanium als Lötmittel.

Anstelle bloßen Germaniumpulvers kann ein Gemisch aus Germaniumpulver und hochreinem Wasser oder auch ein Gemisch aus Germaniumpulver und einem organischen Öl, beispielhaft Kiefernöl, verwendet werden. Die Beimengung von Wasser oder Öl dient der Fixierung des Lotes und zur Verbesserung seiner Fließfähigkeit. Die Beimengungen verschwinden während des Aufheizens rückstandfrei aus der Fügenaht und haben auf deren Festigkeit keinen nachteiligen Einfluß.

Zwei zu verbindende Vorrichtungsteile werden zur Vorbereitung des Lötens so einander gegenübergestellt, daß eine Spaltbreite im Größenbereich von 0,1 mm bis 0,5 mm zwischen den Paßflächen verbleibt. Auch hierbei kann vorgesehen sein, die Paßflächen eben auszubilden und mit einem Abstand innerhalb des vorgenannten Bereiches von 0,1 mm bis 0,5 mm einander gegenüberzustellen, oder auch die Paßflächen gekrümmt auszubilden, wobei die Krümmungen an den beiden Paßflächen in dem Maße vorgesehen ist, daß der Abstand zwischen den Paßflächen zweier Vorrichtungsteile nicht kleiner als 0,1 mm und nicht größer als 0,5 mm ist.

Dabei kann die Spaltbreite über diesen gesamten Flächenbereich gleichbleibend ausgebildet werden oder es kann auch eine innerhalb dieses Bereiches von 0,1 mm bis 0,5 mm variierende Spaltbreite zwischen den beiden sich gegenüberstehenden Paßflächen vorgesehen werden, was sowohl für sich gegenüberstehende ebene als auch gekrümmte Flächen der Fall sein kann.

In einer weiteren Ausgestaltung der Erfindung wird während des Lötprozesses eine Spülung mit Argon vorgenommen. Damit wird Sauerstoff ferngehalten und eine Germaniumoxid-Bildung verhindert, die sich auf die Festigkeit der Fügenaht nachteilig auswirken würde.

Bei der Ausgestaltung nach Unteranspruch 2 besteht die Fügenaht aus artgleichem, bei der Ausgestaltung nach Unteranspruch 3 aus artfremden, aber dem Silizium chemisch ähnlichem Werkstoff, der keine Verunreinigung zuläßt und auch den Stabilitätsforderungen genügt. Besonders vorteilhaft erschließt die vorgeschlagene Verbindungstechnologie die Möglichkeit der Reparatur von Haltevorrichtungen unter Beibehaltung der Hochreinheit, was bisher hinsichtlich defekter Teile nicht realisierbar war. Bisher war im Falle von Materialbrüchen bei derartigen Vorrichtungen stets die Neuanfertigung zumindest einzelner Teile notwendig.

Die Erfindung bezieht sich weiterhin auf eine Haltevorrichtung für Halbleiterscheiben, die nach den vorgenannten Verfahrensschritten hergestellt ist. Die Haltevorrichtung besteht aus einzelnen Vorrichtungsteilen, die nach dem vorbeschriebenen Verfahren miteinander verbunden sind und zwischen denen die Halbleiterscheiben mit im wesentlichen flächenparaleller Ausrichtung aufgenommen sind.

In besonders vorteilhaften Ausgestaltungen der Haltevorrichtung ist vorgesehen, daß die Vorrichtungsteile mit Paßflächen ausgestattet sind, die sich von Vorrichtungsteil zu Vorrichtungsteil gegenüberstehen und die erfindungsgemäß durch Diffusionsschweißung miteinander verschmolzen sind oder zwischen denen Germanium als Lötmittel eingebracht ist, wobei jeweils zwei Vorrichtungsteile an ihren Paßflächen miteinander verlötet sind.

Die Erfindung soll nachfolgend anhand von Ausführungsbeispielen näher erläutert werden. In den zugehörigen Zeichnungen zeigen:
- Fig.1: die Bestandteile einer Haltevorrichtung nach Stand der Technik
- Fig.2: die erfindungsgemäße Gestaltung der Paßflächen in einem ersten Ausführungsbeispiel
- Fig.3: eine erste Gestaltungsvariante der Paßflächen nach Fig.2
- Fig.4: eine zweite Gestaltungsvariante der Paßflächen nach Fig.2
- Fig.5: eine dritte Gestaltungsvariante der Paßflächen nach Fig.2
- Fig.6: die erfindungsgemäße Gestaltung der Paßflächen in einem zweiten Ausführungsbeispiel
- Fig.7: eine erste Gestaltungsvariante der Paßflächen nach Fig.5
- Fig.8: eine zweite Gestaltungsvariante der Paßflächen nach Fig.5
- Fig.9: eine dritte Gestaltungsvariante der Paßflächen nach Fig.5

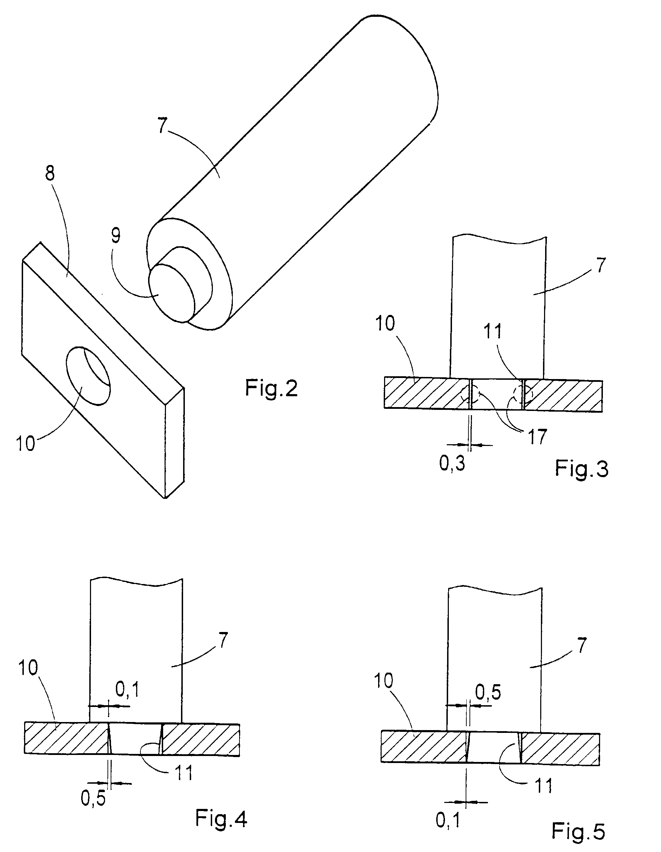

In Fig.2 ist ein zylindrisch ausgebildetes Halteteil 7 zu erkennen, das zur Verbindung mit einem Endteil 8 vorgesehen ist. Das Halteteil 7 entspricht dem Halteelement 1 nach dem Stand der Technik gemäß Fig.1. Ebenso wie das Halteelement 1 weist auch das Halteteil 7 Ausnehmungen auf, die zur Aufnahme der Halbleiterscheiben dienen. Die Ausnehmungen sind jedoch zeichnerisch hier aber nicht nochmals dargestellt worden sind, da ihre Ausgestaltung prinzipiell der Darstellung in Fig.1 entspricht und dort auch zu erkennen ist.

Das Halteteil 7 weist einen zylindrischen Ansatz 9 auf, der bezüglich Form und Ausdehnung mit einer Aussparung 10 am Endteil 8 korrespondiert. Dabei sind die sich am Ansatz 9 und an der Aussparung 10 gegenüberstehenden Paßflächen, d.h. die Umfangsfläche des zylindrischen Ansatzes 9 und die zylindrische Innenfläche der Aussparung 10, so ausgebildet, daß über den gesamten Umfang eine Spaltbreite von 0,3 mm vorhanden ist (vergleiche Fig.3).

In einer weiteren Ausgestaltungsvariante gemäß Fig.4 ist die Breite des Spaltes 11 nicht gleichmäßig über die gesamte Umfangsfläche vorgesehen, sondern der Spalt 11 weist (vom Halteteil 7 aus betrachtet) eine sich vergrößernde Spaltbreite auf, wobei die geringste Spaltbreite 0,1 mm und die größte Spaltbreite bei 0,5 mm beträgt.

Gemäß Fig.5 kann umgekehrt vorgesehen sein, daß die maximale Spaltbreite von 0,5 mm nahe dem Übergang vom zylindrischen Ansatz 9 zum Halteteil 7 ausgebildet ist, während die Spaltbreite mit zunehmender Entfernung vom Halteteil 7 abnimmt. Dabei kann die Paßfläche am Halteteil 7 und/oder die Paßfläche am Ansatz 9 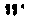 schräg"-gestellt sein, d.h. in einem von 90° abweichenden Winkel in Bezug auf die jeweilige Grundfläche verlaufen. Von Bedeutung ist dabei lediglich, daß beide sich gegenüberstehenden Paßflächen gegeneinander geneigt sind.

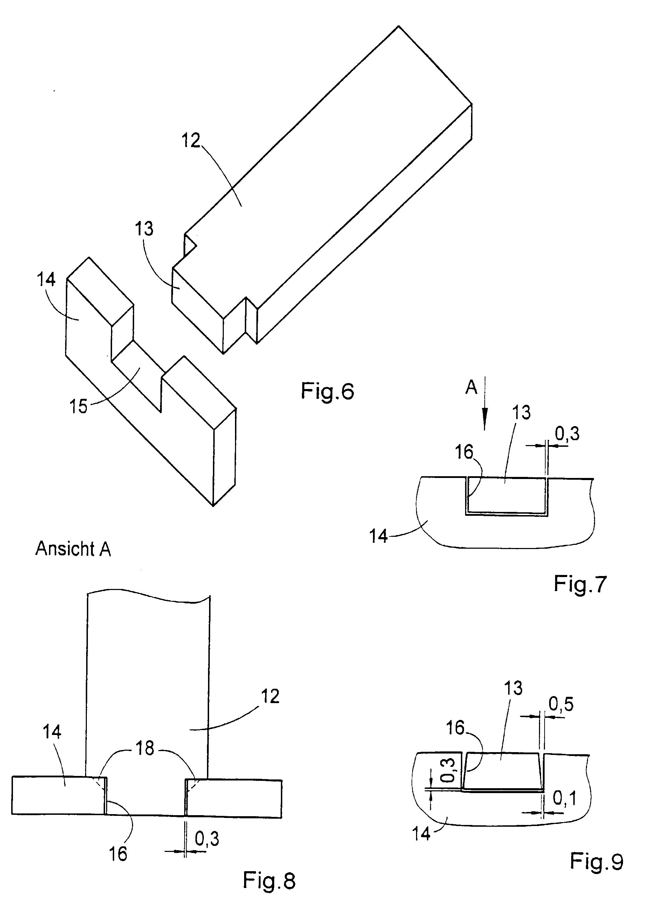

Von Vorteil kann es auch sein, wenn in die Paßflächen Nuten 17 und/oder fasenartige Anschrägungen 18 eingearbeitet sind, wie das beispielhaft in Fig.3 und Fig.8 dargestellt ist. Damit wird erreicht, daß das Lot eine funktionell günstigere Verteilung zwischen den Paßflächen einnehmen kann.

In Fig.6 ist ein Halteteil 12 dargestellt, das einen rechteckigen Querschnitt aufweist und mit einem quaderförmigen Ansatz 13 versehen ist. Das Halteteil 12 ist zur Verbindung mit einem Vorrichtungsteil 14 vorgesehen, dem eine bezüglich ihrer Form und Größe im quaderförmigen Ansatz 13 entsprechende Aussparung 15 eingearbeitet ist.

Auch hier verbleibt beim Fügen des Halteteils 12 mit dem Endteil 14 zwischen der Außenfläche des quaderförmigen Ansatzes 13 und der Innenfläche der Aussparung 15 ein Spalt 16, der, wie in Fig.8 dargestellt, über die gesamten sich gegenüberstehenden Flächenabschnitte hinweg eine gleichmäßige Breite von 0,3 mm aufweist.

In Fig.8 ist diese Konfiguration in einer Ansicht A aus Fig.7 dargestellt. Auch hier ist die gleichbleibende Spaltbreite des Spaltes 16 zu erkennen.

In Fig.9 dagegen ist beispielhaft eine Ausgestaltungsvariante der Erfindung bei ungleichmäßiger Spaltbreite zwischen den sich gegenüberstehenden Flächen dargestellt. Hier variiert die Spaltbreite im Bereich von 0,1 mm bis 0,5 mm.

Die gesamte Haltevorrichtung für Halbleiterscheiben besteht ähnlich dem in Fig.1 dargestellten Stand der Technik aus zwei platten- bzw. scheibenförmigen Endträgern, zwischen denen sich mehrere Halteelemente bzw. -teile befinden, die geeignet sind, eine Mehrzahl von Halbleiterscheiben im wesentlichen flächenparallel aufzunehmen.

Diese Halteelemente können z.B. Querschnittsformen wie in Fig.2 und Fig.6 dargestellt besitzen. Weitere denkbare Ausführungsformen der Halteelemente sind der Kreisform der aufzunehmenden Halbleiterscheiben angepaßte Zylindermantelteile oder -abschnitte mit im Inneren angeordneten nutenförmigen Ausnehmungen für die Fixierung der Halbleiterscheiben.

Vorstehend genannte Teile der Haltevorrichtung sind aus ein- oder polykristallinem Silizium höchster Reinheit gefertigt. Die Oberflächen sind mechanisch bearbeitet, teils bis zur Oberflächenpolitur.

Zwecks Diffusionsverschweißung der Teile werden diese zunächst gereinigt, in der vorgesehenen Position fixiert und über einen Zeitraum von 2 bis 4 Stunden unter einem Anpreßdruck von bis zu 10 N/mm² bei einer Temperatur von 1.000° C bis 1.300° C erwärmt. Dabei diffundieren Atome des Teilewerkstoffs über die Rauhigkeitsspitzen der zu fügenden, einander berührenden Teileflächen, so daß es zu einer stabilen stoffschlüssigen Verbindung der einzelnen Teile der Vorrichtung kommt.

Die Verbindung der Teile durch Löten wird wie folgt vorgenommen: Nach gründlicher Reinigung der Vorrichtungsteile werden diese in der vorgesehenen Position derart fixiert, daß jeweils eine Fuge mit der Breite von 0,1 bis 0,5 mm zwischen zwei Paßflächen verbleibt. In diese Fuge wird pulverisiertes Germanium mit einer Korngröße kleiner als 50 µm eingebracht. Anschließend werden die Vorrichtungsteile bei einem Druck von 30 mbar auf eine Temperatur von 900° C bis 1.350° C erwärmt, bis alle Teile diese Temperatur erreicht haben.

Der zeitliche Ablauf ist dabei abhängig von der Masse bzw. Ausdehnung der Teile und beträgt ca. 1,5 Std. Nach Annäherung an die Schmelztemperatur des Germaniums (958,5° C) füllt dieses im teigigen oder flüssigen Zustand die Spalten 11, 16 und, sofern vorhanden, die Nuten 17 bzw. die durch Anschrägungen 18 gebildeten Hohlräume weitgehend aus und verbindet sich an den Paßflächen mit den Vorrichtungsteilen. Während des Lötprozesses kann mit Argon gespült werden, um Sauerstoff fernzuhalten.

Die Erfindung eignet sich vorzugsweise zur Herstellung einer Haltevorrichtung für Halbleiterscheiben aus Silizium in ein- oder polykristalliner Form, ist jedoch nicht hierauf beschränkt. Bei entsprechender Ausgestaltung insbesondere der Halteelemente ist auch die Aufnahme anderer Produkte als nur der Halbleiterscheiben möglich.

Auch ist es bei entsprechender Modifizierung des erfindungsgemäßen Verfahrens möglich Rohre, Platten, Gestelle oder auch anderweitige Teile und Baugruppen herzustellen, die aus mehreren, einzeln vorgefertigten und aus mono- bzw. polykristallinem Silizium bestehenden Teilstücken zusammengefügt sind. Ebenso wie bei der beschriebenen Verfahrensweise zur Herstellung einer Haltevorrichtung für Halbleiterscheiben sind dabei die einzeln vorgefertigten Teilstücke mit zueinander korrespondierenden Paßflächen zu versehen, die sich während des Fügeprozesses gegenüberstehen. Die benachbarten Teile werden unter Anwendung der erfindungsgemäßen Verfahrensschritte, ähnlich wie anhand der Haltevorrichtung für Halbleiterscheiben beschrieben, durch Diffusionsschweißen bzw. Löten an den Paßflächen miteinander verbunden.

So können vorteilhaft Rohre aus mono- oder polykristallinem Silizium hergestellt werden, die beispielhaft einen Außendurchmesser von 200mm bei einer Wandstärke von 5mm aufweisen und deren Gesamtlänge mindestens 900mm beträgt. Im Stand der Technik ist es aus fertigungstechnologisch bedingten Gründen nicht möglich, ein solches Silizium-Rohr einstückig zu fertigen. Nach dem erfindungsgemäßen Verfahren aber können beispielsweise drei Rohrabschnitte von jeweils 300mm Länge zu dem Rohr der Gesamtlänge von 900 mm gefügt werden. Dabei erhält man aufgrund der unlösbaren stoffschlüssigen Verbindung dieser drei Abschnitte miteinander ein Rohr der gewünschten Gesamtlänge, das sich durch hohe mechanische und thermische Stabilität auszeichnet und zudem unter Hochtemperatur-Bedingungen (bis ca. 1350 C ° Celsius) nutzbar ist.

## Patentansprüche

1. Verfahren zur Herstellung einer Haltevorrichtung für Halbleiterscheiben (Wafer), bei dem mehrere Vorrichtungsteile (7,8;12,14) zur Haltevorrichtung zusammengesetzt und miteinander verbunden werden, **dadurch gekennzeichnet**, daß
- die Vorrichtungsteile (7,8;12,14) zunächst einzeln aus ein- oder polykristallinem Silizium gefertigt und mit miteinander korrespondierenden Paßflächen versehen werden,
- hiernach die Vorrichtungsteile (7,8;12,14), die in der Haltevorrichtung einander benachbart sind, mit sich gegenüberstehenden Paßflächen aneinandergefügt und
- schließlich an den Paßflächen durch Diffusionsschweißen und/oder durch Löten, wobei Germaniumpulver als Lot verwendet wird, miteinander verbunden werden.

2. Verfahren nach Anspruch 1, dadurch gekennzeichnet, daß die Diffusionsschweißung bei einer Zeitdauer von zwei bis vier Stunden unter einem Anpreßdruck von bis zu 10 N/mm² bei einer Temperatur von 1000 °C bis 1300 °C vorgenommen wird.

3. Verfahren nach Anspruch 1, dadurch gekennzeichnet, daß zum Zweck der Lötverbindung zweier benachbarter Vorrichtungsteile (7,8;12,14) zunächst pulverisiertes Germanium mit einer Korngröße kleiner als 50 µm und einer Schichtdicke von 0,1 bis 0,5 mm zwischen jeweils zwei Paßflächen dieser Vorrichtungsteile eingebracht und anschließend die Teile an den Paßflächen bei einem Druck kleiner 30 mbar und einer Umgebungstemperatur zwischen 900 °C bis 1350 °C miteinander verbunden werden.

4. Verfahren nach Anspruch 3, dadurch gekennzeichnet, daß das Germaniumpulver vor dem Einbringen zwischen die Paßflächen mit einer organischen Flüssigkeit, bevorzugt mit hochreinem Wasser, besonders bevorzugt mit einem organischen Öl, vermischt wird.

5. Verfahren nach Anspruch 3 oder 4, dadurch gekennzeichnet, daß nach dem Lötprozeß eine Spülung der miteinander verbundenen Vorrichtungsteile (7,8;12,14) mit Argon vorgenommen wird.

6. Aufnahmevorrichtung für Halbleiterscheiben (Wafer), bestehend aus mehreren miteinander verbundenen Vorrichtungsteilen (7,8;12,14), die einzeln aus Silizium vorgefertigt und miteinander verbunden sind, **dadurch gekennzeichnet**, daß die Vorrichtungsteile (7,8;12,14) aus ein- *oder polykristallinem* Silizium bestehen und gemäß den vorgenannten Verfahrensansprüchen 1 bis 4 durch Diffusionsschweißung und/oder durch Löten unter Verwendung von Germaniumpulver miteinander verbunden sind.

7. Aufnahmevorrichtung nach Anspruch 6, dadurch gekennzeichnet, daß die Vorrichtungsteile mit Paßflächen versehen sind, die sich an benachbarten Vorrichtungsteilen (7,8;12,14) gegenüberstehen und die durch Diffusionsschweißung miteinander verschmolzen sind.

8. Aufnahmevorrichtung nach Anspruch 6, dadurch gekennzeichnet, daß die Vorrichtungsteile mit Paßflächen versehen sind, die sich unter Ausbildung eines Spaltes (11) an benachbarten Vorrichtungsteilen (7,8;12,14) gegenüberstehen, wobei in den Spalt (11) zwischen den Paßflächen Germanium als Lötmittel eingebracht ist.

9. Aufnahmevorrichtung nach Anspruch 8, dadurch gekennzeichnet, daß die Paßflächen Aussparungen in Form von Nuten (17) und/oder Anschrägungen (18) aufweisen.
